# EUROPÄISCHE PATENTSCHRIFT

(11) **EP 1 116 040 B1**
(45) Veröffentlichungstag und Bekanntmachung des Hinweises auf die Patenterteilung: **23.11.2005**
(21) Anmeldenummer: 99955804.2
(22) Anmeldetag: 22.09.1999
(51) Int. Cl.: G01R 15/18

(54) **Verfahren zur Abbildung von Gleichströmen und Gleichstromwandler zur Durchführung des Verfahrens**
Method of reproducing direct currents and direct current transformer for carrying out said method
Procédé pour la reproduction de courants continus et transformateur à courant continu pour la mise en oeuvre de ce procédé

(30) Priorität: 22.09.1998 DE 19845778
(43) Veröffentlichungstag der Anmeldung: 18.07.2001
(73) Patentinhaber: SIEMENS AKTIENGESELLSCHAFT, 80333 München (DE)
(72) Erfinder: BAUMGAERTEL, Ulrich, D-13599 Berlin (DE); ROEHL, Wolfgang, D-13503 Berlin (DE); FRANKE, Henry, D-13189 Berlin (DE); HOCHGRAEF, Holger, D-16845 Ganzer (DE)
(86) Internationale Anmeldenummer: PCT/DE1999/003088
(87) Internationale Veröffentlichungsnummer: WO 2000/017663

(56) Entgegenhaltungen:
- GB-A- 2 029 973
- GB-A- 2 137 764
- PETTER J ET AL: "SURVEY OF DC CURRENT MEASUREMENT TECHNIQUES FOR HIGH CURRENT PRECISION POWER SUPPLIES" PROCEEDINGS OF THE NUCLEAR SCIENCE SYMPOSIUM AND MEDICAL IMAGING CONFERENCE,US,NEW YORK, IEEE, Bd. -, 1991, Seiten 961-967, XP000347983 ISBN: 0-7803-0513-2

## Beschreibung

Die Erfindung betrifft ein Verfahren zur Abbildung von Gleichströmen, insbesondere für die Verwendung in Gleichspannungs-Schaltgeräten, mit Hilfe einer von dem zu messenden Gleichstrom durchflossenen Primärwicklung, die mit einer Sekundärwicklung über einen Eisenkern magnetisch gekoppelt ist und einen zur Durchführung des Verfahrens geeigneten Gleichstromwandler.

Die Erfassung von Strömen in Gleichstromkreisen ist mit größeren technischen Problemen verbunden als die von Strömen in Wechselstromkreisen, in denen mittels magnetischer Wandler eine Übertragung auf eine Meßeinrichtung oder auf die Auslöseschaltung eines Schaltgerätes erfolgen kann.

Für Niederspannungs-Schaltgeräte besteht darüber hinaus die Forderung, daß die Messung möglichst aus dem System heraus erfolgen soll, d. h. ohne die Bereitstellung fremder Energie durch eine zusätzliche Energiequelle, die eine Hilfsspannung zur Verfügung stellt, was bei Wechselstromnetzen ebenfalls ein nur geringes Problem ist, oder zumindest mit einer Energiequelle mit nur geringer Leistung.

Bekannt ist die Messung der Primärströme auf magnetischem Wege, also mit Hilfe von Hallsonden oder Feldplatten. Die Methode hat sich, zumindest für den hier bevorzugten Einsatzfall, jedoch als wenig geeignet erwiesen, da die Abbildgenauigkeit des Primärstromes unzureichend ist und es so leicht zu Fehlauslösungen des Überstromauslösers kommen kann.

Bekannt ist es auch, einen Meßwiderstand (Shunt) in den Primärstromkreis einzufügen und die Spannung über diesem Meßwiderstand einem Trennverstärker zuzuführen, der ausgangsseitig auf die Auslöseschaltung einwirkt. Die Lösung ist jedoch technisch sehr aufwendig wegen der Anforderungen, die der Trennverstärker erfüllen muß. Außerdem entsteht eine ständige, hohe Verlustleistung im Meßwiderstand.

Mit der EP-A 0 651 258 ist ein Meßverfahren für Gleichströme bekannt, bei dem der Primärleiter mit einer Erregerwicklung über einen Eisenkern magnetisch gekoppelt wird. Letzterer wird mit einem regelmäßigen, dreieckförmigen Wechselstrom erregt, der in einer weiteren, als Meßspule dienenden Wicklung regelmäßig beabstandete Impulse entstehen läßt. Wird der Eisenkern nun durch den Primärgleichstrom in der einen oder anderen Richtung vormagnetisiert, so ändert sich aufgrund der Verschiebung der Hysteresekurve des Eisenkerns der Abstand der gemessenen Impulse, der als Maß für den zu messenden Primärstrom ausgewertet werden kann. Die Lösung ist ebenfalls schaltungstechnisch sehr aufwendig und erfordert die ständige Bereitstellung einer Hilfsspannung mit einer entsprechenden Leistung, so daß ein nicht unbeträchtlicher Energieaufwand entsteht.

Ein weiteres Verfahren zur Messung von Gleichströmen beruht auf der Kompensation eines durch den Gleichstrom in einem Eisenkern hervorgerufenen Magnetfeldes durch eine Erregerwicklung. Zur Steuerung des Kompensationsstromes in der Erregerwicklung wird das Magnetfeld in einem Luftspalt des Eisenkerns mit Hilfe eines Magnetfeldsensors gemessen. Der in der Erregerwicklung fließende Strom bei erfolgter Kompensation, d. h. wenn das durch den Magnetfeldsensor gemessene Gesamtfeld zu Null geworden ist, dient als Maß für den Primärgleichstrom. Das Verfahren ist beispielsweise aus der EP-A 0 294 590 oder aus der DE-A 38 15. 100 bekannt.

Eine weitere Möglichkeit mit Hilfe der Magnetfeldkompensation ist in GB-A 2 029 973 aufgezeigt. Nach dieser Lösung wird in die Kompensationswicklung ständig wiederholend ein rampenförmiger Strom eingespeist und das Magnetfeld im Eisenkern über eine Indikatorwicklung gemessen.

Das Kompensationsverfahren erfordert für das Bereitstellen eines ständigen Kompensationsstromes ebenfalls einen beträchtlichen Energieaufwand und ist für den vorgenannten Zweck so nicht geeignet.

Der Erfindung liegt die Aufgabe zugrunde, ein Meßverfahren und schließlich einen Gleichstromwandler anzugeben, mit denen sich Gleichströme wesentlich energieärmer und möglichst genau abbilden lassen.

Erfindungsgemäß wird die Aufgabe dadurch gelöst, daß das von einer Sekundärwicklung eines in einer Primärwicklung des von dem zu messenden Strom durchflossenen Eisenkerns gelieferte Stromsignal integriert und der integrierte Stromwert einer Meßeinrichtung oder einer Auslöseschaltung eines Schaltgerätes zugeführt wird, wobei in vorgegebenen Zeitabständen ein Abgleich des integrierten Stromwertes durchgeführt wird, indem der zu messende Primärstrom nach dem Kompensationsverfahren, bei dem das Magnetfeld im Eisenkern durch einen dem Primärstrom entgegen gerichteten Strom in einer Kompensationswicklung auf Null gesteuert wird, unter Zuhilfenahme eines Magnetfeldsensors zur Messung des Magnetfeldes im Eisenkern ermittelt und der integrierte Stromwert auf diesen Wert korrigiert wird.

Das Verfahren kann zweckmäßig so durchgeführt werden, daß für die Messung nach dem Kompensationsverfahren die Sekundärwicklung als Kompensationswicklung benutzt wird.

Das Kompensationsverfahren kann vorteilhaft so durchgeführt werden, daß in die Sekundärwicklung oder eine separate Kompensationswicklung ein linear ansteigender Gleichstrom eingespeist wird.

Das Verfahren kommt mit einem Bruchteil des Energieaufwandes zuvor bekannter Gleichstromwandler aus, weil das Kompensationsverfahren nur in Zeitabständen durchgeführt wird, um die Drift des mit dem Integrationsverfahren ermittelten Stromwertes zu beseitigen.

Ein zur Durchführung des Verfahrens geeigneter Gleichstromwandler weist erfindungsgemäß eine von dem zu messenden Primärgleichstrom durchflossene Primärwicklung und eine Sekundärwicklung auf, die über einen Eisenkern magnetisch gekoppelt sind, sowie einen Magnetfeldsensor zur Messung des Magnetfeldes des Eisenkerns, eine mit der Sekundärwicklung verbundene Integrierschaltung, deren Ausgang mit einer Meßeinrichtung oder einer Auslöseschaltung eines Schaltgerätes verbunden ist und eine mit der Sekundärwicklung über einen Umschalter oder mit einer separaten, auf den Eisenkern gewikkelten Kompensationswicklung verbundene Kompensationsschaltung. Diese besteht aus einer steuerbaren Gleichstromquelle und einer den Stromwert der Gleichstromquelle bei kompensiertem Magnetfeld, das heißt bei einem magnetischen Fluß gleich Null, zum Abgleich der Integrierschaltung verarbeitenden Auswerteschaltung.

Der Magnetfeldsensor kann eine Hallsonde, ein Feldplatten-Sensor oder eine Indikatorwicklung sein, in die ein symmetrischer Wechselstrom eingeprägt wird und dessen Spannungsunsymmetrie bzw. -symmetrie ein Maß für das Magnetfeld im Eisenkern ist.

Zweckmäßig ist der Eisenkern mit einem Lufspalt versehen, in dem bzw. in dessen Nähe der Magnetfeldsensor angeordnet wird.

Die Sekundärwicklung liefert ein Signal, welches dem di/dt des Primärgleichstromes entspricht. Die nachgeschaltete Auswerteschaltung, vorzugsweise auf Mikroprozessor-Basis, bildet durch Integration des Signals aus der Sekundärwicklung den Primärgleichstrom ab und kann mit diesem Wert in bekannter Weise den Überstromschutz ausführen.

Zur Ermittlung des Primärstromes ist eine Langzeitintegration notwendig, bei der geringe Fehler über sehr lange Zeiten zu großen Abweichungen zwischen dem Rechenwert und dem wahren Primärstrom führen können, so daß ein Überstromauslöser fehlerhaft arbeiten würde. Zur Vermeidung dieses unerwünschten Langzeiteffektes wird in gewissen Zeitabständen mit Hilfe des Magnetfeldsensors eine Strommessung durchgeführt. Dazu wird in die Sekundärwicklung oder eine separate Kompensationswicklung ein Gleichstrom eingespeist, der von Null beginnend mit der Zeit linear ansteigend eine Rampe hochfährt. Zur gleichen Zeit wird das Ausgangssignal des Magnetfeldsensors beobachtet. Zeigt das Signal einen Umkehrpunkt oder einen Polaritätswechsel, je nach dem Typ des verwendeten Magnetfeldsensors, so ist das Magnetfeld im Luftspalt Null und der Kompensationsstrom, multipliziert mit der Windungszahl der Sekundär- bzw. Kompensationswicklung, gleich dem Primärstrom, mit dem dann der zuvor integrierte Stromwert korrigiert wird. Danach kann die Stromerfassung wieder durch Integration erfolgen.

Wird für die Magnetfeldmessung eine Indikatorwicklung am Eisenkern benutzt, so wird in diese Indikatorwicklung ein symmetrischer Wechselstrom eingeprägt. Parallel zur Indikatorwicklung wird die Spannung gemessen. Ist das Magnetfeld ungleich Null, so ergibt sich wegen der magnetischen Charakteristik des Eisenkernes eine mehr oder weniger starke Unsymmetrie der Spannung. Wird das Magnetfeld bei ansteigendem Kompensationsstrom schließlich Null, so ergibt sich eine symmetrische Wechselspannung. Der gesuchte Meßpunkt ist dann erreicht. Im Gegensatz zu dem zum Stand der Technik beschriebenen Kompensationsverfahren muß dabei keine Regelung des Kompensationsstroms erfolgen. Vielmehr kann der Meßvorgang abgebrochen werden, wenn durch den linear ansteigenden Kompensationsstrom das Magnetfeld im Eisenkern zu Null geworden ist.

Die Verwendung einer solchen Indikatorwicklung hat den Vorteil gegenüber anderen Magnetfeldsensoren, daß ihre Temperaturfestigkeit wesentlich höher ist. Die Temperaturfestigkeit hängt nur von der Isolationsklasse der Wicklung ab. Übertemperaturen bis 200°C können bei entsprechender Isolation zugelassen werden.

Die Erfindung soll nachfolgend anhand eines Ausführungsbeispiels näher erläutert werden. In den zugehörigen Zeichnungen zeigen:
- Fig. 1: eine Prinzipdarstellung der für den Gleichstromwandler benötigten Anordnung
- Fig. 2: das beim regelmäßigen Abgleich mit verschiedenen Magnetfeldsensoren entstehende Signal
- Fig. 3: ein Blockschaltbild einer Anordnung zur Kompensationsmessung.

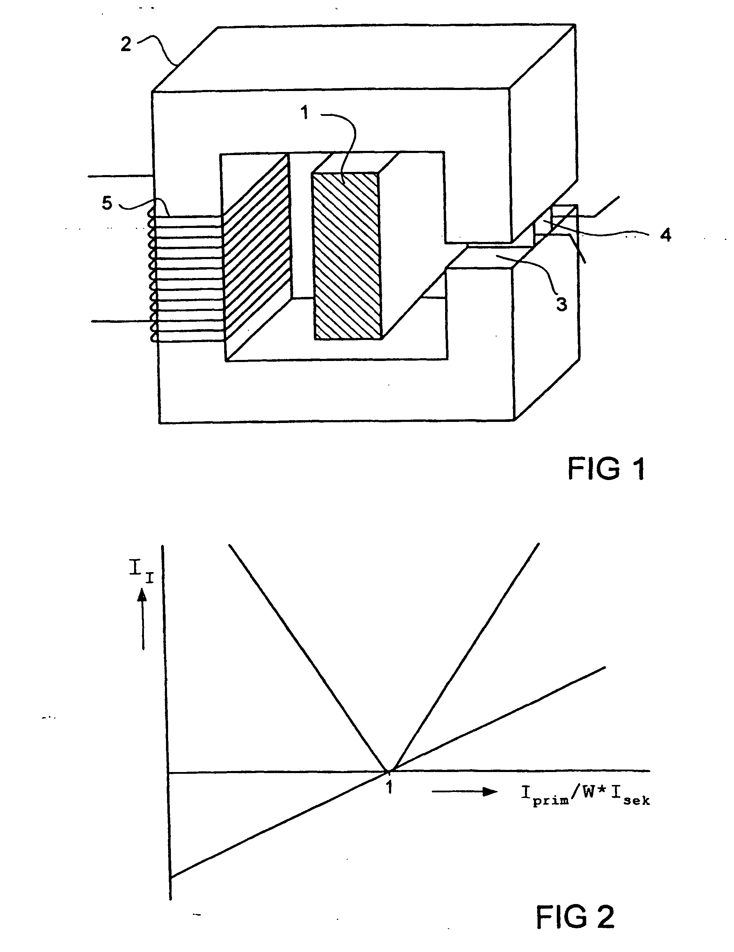

Fig. 1 zeigt in einer Prinzipdarstellung die Anordnung, die zur Durchführung des Verfahrens benötigt wird. Ein Primärstromleiter 1 eines Gleichspannungsnetzes wird durch einen Eisenkern 2 des Gleichstromwandlers hindurchgeführt. Der Eisenkern 2 ist mit einem Luftspalt 3 versehen, in dem ein Magnetfeldsensor 4 untergebracht ist. Auf den Eisenkern 2 ist eine Sekundärwicklung 5 aufgebracht, deren Strom das zu verwertende Signal liefert. Das Stromsignal wird in einer hier nicht gezeigten Integriersschaltung integriert und liefert dann ein Abbild für den Primärgleichstrom I_{Prim}.

Zum Abgleich des integrierten Stromwertes wird eine zweite Strommessung mit Hilfe des Magnetfeldsensors 4 durchgeführt. Dazu wird die bis dahin durchgeführte Strommessung kurzzeitig unterbrochen und in die Sekundärwicklung 5 ein linear ansteigender Kompensationsstrom Iₛₑₖ eingespeist, bis das Ausgangssignal I_{I}, des Magnetfeldsensors 4 einen Umkehrpunkt bzw. einen Polarisationswechsel erreicht, wie in Fig. 2 gezeigt ist. Der mit der Windungszahl w multiplizierte Kompensationsstrom Iₛₑₖ entspricht dem zu messenden Primärgleichstrom I_{Prim}. Mit diesem gemessenen Wert wird der zuvor mittels Integration ermittelte Stromwert nun korrigiert.

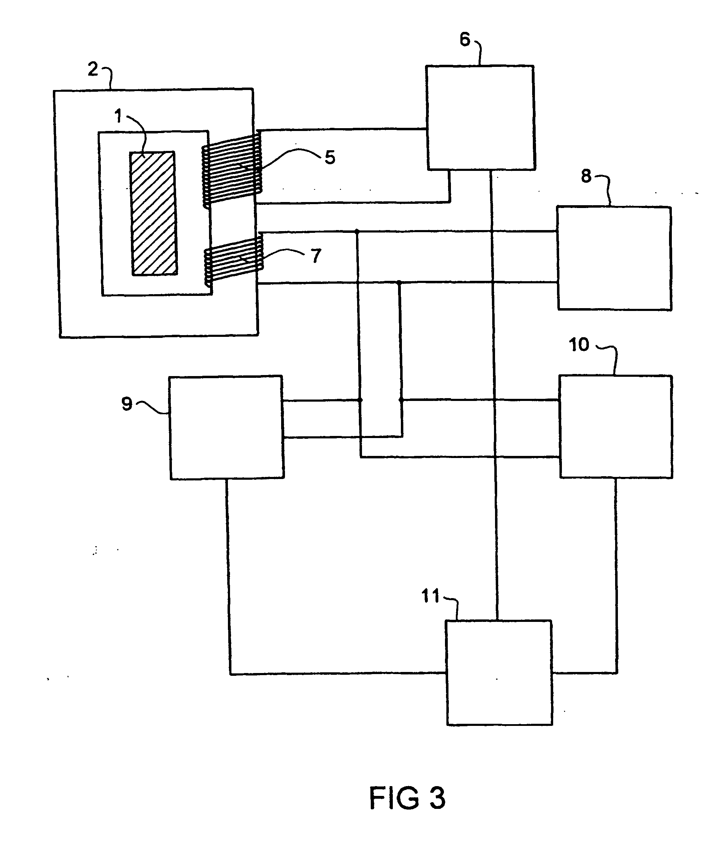

Fig. 3 zeigt eine Möglichkeit zur Realisierung der Feldmessung im Eisenkern 2. Die Sekundärwicklung 5 wird hierbei als Kompensationswicklung verwendet. Gezeigt ist nur der Betrieb während der Kompensationsphase. Die Sekundärwicklung 5 ist mit einer steuerbaren Gleichstromquelle 6 verbunden, die beispielsweise einen linear ansteigenden Strom in die Sekundärwicklung 5 einspeist.

In eine Indikatorwicklung 7 wird ein symmetrischer Wechselstrom, der von einer Wechselstromquelle 8 geliefert wird, eingespeist. Die Spannung über der Indikatorwicklung 7 wird gemessen. In der positiven Halbwelle werden in einem Spitzenwertspeicher 9 der positive Spitzenwert und in der negativen Halbwelle in einem Spitzenwertspeicher 10 der negative Spitzenwert gespeichert. Als Spitzenwertspeicher sind z. B. Kondensatoren geeignet. Beide Werte werden ansschließend in einem Komparator 11 verglichen.

Solange der Komparatorwert ungleich Null ist, bedeutet das, daß die Spannung wegen der magnetischen Eigenschaften des durch den Primärstrom I_{Prim} vormagnetisierten Eisenkerns 2 unsymmetrisch ist.

Beträgt der Komparatorwert Null, so ist die gemessene Wechselspannung über der Indikatorwicklung 7 symmetrisch und somit ein Maß dafür, daß das Magnetfeld im Eisenkern Null, d. h. der Primärgleichstrom I_{Prim} kompensiert ist. Der Strom Iₛₑₖ in der Sekundärwicklung 5 ist in diesem Augenblick ein Maß für den Primärgleichstrom I_{Prim}. Der Wert wird festgehalten, um mit ihm anschließend den mit dem Integrationsverfahren gewonnenen Stromwert zu korrigieren. Die Integration und die Stromwertkorrektur erfolgen zweckmäßig digital in einem hier nicht gezeigten Mikroprozessor. Für den Fall der Anwendung in einer Auslöseschaltung eines Gleichstromschaltgerätes ist die Auslöseschaltung ohnehin bereits mit einem Mikroprozessor ausgerüstet, der hierfür mitverwendet werden kann.

## Patentansprüche

1. Verfahren zur Abbildung von Gleichströmen, insbesondere für die Verwendung in Überstromauslösern von Gleichspannungs-Schaltgeräten, mit Hilfe einer von dem zu messenden Gleichstrom durchflossenen Primärwicklung (1), die mit einer Sekundärwicklung (5) über einen Eisenkern (2) magnetisch gekoppelt ist,
**dadurch gekennzeichnet**
**daß** das von der Sekundärwicklung (5), gelieferte Stromsignal integriert und der integrierte Stromwert einer Meßeinrichtung oder einer Auslöseschaltung eines Schaltgerätes zugeführt wird, wobei in vorgegebenen Zeitabständen ein Abgleich des integrierten Stromwertes durchgeführt wird, indem der zu messende Primärstrom nach dem Kompensationsverfahren, bei dem das Magnetfeld im Eisenkern (2) durch einen dem Primärstrom entgegen gerichteten Strom in einer Kompensationswicklung auf Null gesteuert wird, unter Zuhilfenahme eines Magnetfeldsensors (4) zur Messung des Magnetfeldes im Eisenkern (2) ermittelt und der integrierte Stromwert auf diesen Wert korrigiert wird.

2. Verfahren nach Anspruch 1,
**dadurch gekennzeichnet**
**daß** zur Durchführung des Kompensationsverfahrens die Sekundärwicklung (5) als Kompensationswicklung benutzt wird.

3. Verfahren nach Anspruch 1 oder 2,
**dadurch gekennzeichnet**
**daß** zur Durchführung des Kompensationsverfahrens in die Sekundärwicklung (5) oder eine separate Kompensationswicklung ein linear ansteigender Gleichstrom eingespeist wird.

4. Gleichstromwandler mit einer von dem zu messenden Gleichstrom durchflossenen Primärwicklung (1), die mit einer Sekundärwicklung (5) über einen Eisenkern (2) magnetisch gekoppelt ist zur Durchführung des Verfahrens nach einem der vorhergehenden Ansprüche,
**gekennzeichnet durch**
einen Magnetfeldsensor (4) zur Messung des Magnetfeldes des Eisenkerns (2), eine mit der Sekundärwicklung (5) verbundene Integrierschaltung, deren Ausgang mit einer Meßeinrichtung oder einer Auslöseschaltung eines Schaltgerätes verbunden ist und eine mit der Sekundärwicklung (5) über einen Umschalter oder mit einer separaten, auf den Eisenkern (2) gewickelten Kompensationswicklung verbundene Kompensationsschaltung, bestehend aus einer steuerbaren Gleichstromquelle (6) und einer den Stromwert der Gleichstromquelle (6) bei kompensiertem Magnetfeld zum Abgleich der Integrierschaltung verarbeitenden Auswerteschaltung (9, 10, 11).

5. Gleichstromwandler nach Anspruch 4,
**dadurch gekennzeichnet**
**daß** der Eisenkern (2) einen Luftspalt (3) aufweist, in dem oder in dessen Nähe der Magnetfeldsensor (4) angeordnet ist.

6. Gleichstromwandler nach Anspruch 4 oder 5,
**dadurch gekennzeichnet**
**daß** der Magnetfeldsensor (4) eine Hallsonde ist.

7. Gleichstromwandler nach. Anspruch 4 oder 5,
**dadurch gekennzeichnet**
**daß** der Magnetfeldsensor (4) ein Feldplatten-Sensor ist.

8. Gleichstromwandler nach Anspruch 4 oder 5,
**dadurch gekennzeichnet**
**daß** der Magnetfeldsensor (4) eine mit einem symmetrischen Wechselstrom beaufschlagbare Indikatorwicklung (7) ist, deren Spannungsunsymmetrie in der Auswerteschaltung (9, 10, 11) zur Messung des Magnetfeldes im Eisenkern (2) verwertbar ist.

## Claims

1. Method for reproducing direct currents, in particular for use in overcurrent releases in DC switchgear, with the aid of a primary winding (1) through which the direct current to be measured flows and which is magnetically coupled to a secondary winding (5) via an iron core (2),
**characterized**
**in that** the current signal supplied from the secondary winding (5) is integrated, and the integrated current value is supplied to a measurement device or to a tripping circuit of a switching device, with trimming of the integrated current value being carried out at predetermined time intervals by the primary current to be measured being determined with the assistance of a magnetic field sensor (4) for measuring the magnetic field in the iron core (2), using the compensation method in which the magnetic field in the iron core (2) is set to zero by means of a current, in the opposite direction to the primary current, in a compensation winding, and by the integrated current value being corrected to this value.

2. Method according to Claim 1,
**characterized**
**in that** the secondary winding (5) is used as the compensation winding in order to carry out the compensation method.

3. Method according to Claim 1 or 2,
**characterized**
**in that** a linear-rising direct current is fed into the secondary winding (5) or into a separate compensation winding in order to carry out the compensation method.

4. DC/DC converter having a primary winding (1) through which the direct current to be measured flows and which is magnetically coupled to a secondary winding (5) via an iron core (2), for carrying out the method as claimed in one of the preceding claims,
**characterized by**
a magnetic field sensor (4) for measuring the magnetic field of the iron core (2), an integration circuit which is connected to the secondary winding (5) and whose output is connected to a measurement device or to a tripping circuit of a switching device, and a compensation circuit which is connected to the secondary winding (5) via a changeover switch or is connected to a separate compensation winding wound on the iron core (2), comprising a controllable DC source (6) and an evaluation circuit (9, 10, 11) which processes the current value of the DC source (6) when the magnetic field has been compensated, in order to trim the integration circuit.

5. The DC/DC converter according to Claim 4,
**characterized**
**in that** the iron core (2) has an air gap (3), in which or in whose vicinity the magnetic field sensor (4) is arranged.

6. DC/DC converter according to Claim 4 or 5,
**characterized**
**in that** the magnetic field sensor (4) is a Hall probe.

7. DC/DC converter according to Claim 4 or 5,
**characterized**
**in that** the magnetic field sensor (4) is a magnetoresistive sensor.

8. DC/DC converter according to Claim 4 or 5,
**characterized**
**in that** the magnetic field sensor (4) is an indicator winding (7) to which a balanced alternating current can be applied and whose voltage imbalance can be evaluated in the evaluation circuit (9, 10, 11) in order to measure the magnetic field in the iron core (2).

## Revendications

1. Procédé pour représenter des courants continus, à utiliser en particulier dans des déclencheurs à maximum de courant d'appareils de coupure à tension continue, à l'aide d'un enroulement primaire (1) parcouru par le courant continu à mesurer et couplé magnétiquement à un enroulement secondaire (5) par l'intermédiaire d'un noyau en fer doux (2),
**caractérisé en ce que** le signal de courant fourni par l'enroulement secondaire (5) est intégré et la valeur intégrée du courant est acheminée à un dispositif de mesure ou à un circuit de déclenchement d'un appareil de coupure, la valeur intégrée du courant étant ajustée à des intervalles de temps prédéfinis en déterminant le courant primaire à mesurer par le procédé de compensation, dans lequel le champ magnétique dans le noyau en fer doux (2) est réglé sur zéro par un courant dirigé en sens contraire du courant primaire dans un enroulement de compensation, à l'aide d'un détecteur de champ magnétique (4) pour mesurer le champ magnétique dans le noyau en fer doux (2) et la valeur du courant intégrée est corrigée en prenant cette valeur.

2. Procédé selon la revendication 1, **caractérisé en ce que** l'enroulement secondaire (5) est utilisé comme enroulement de compensation pour exécuter le procédé de compensation.

3. Procédé selon la revendication 1 ou 2, **caractérisé en ce que**, pour exécuter le procédé de compensation, un courant continu à croissance linéaire est fourni dans l'enroulement secondaire (5) ou dans un enroulement distinct de compensation.

4. Transducteur de mesure pour courant continu comportant un enroulement primaire (1) parcouru par le courant continu à mesurer et couplé magnétiquement à un enroulement secondaire (5) par l'intermédiaire d'un noyau en fer doux (2) afin d'exécuter le procédé selon l'une des revendications précédentes,
**caractérisé par** un détecteur de champ magnétique (4) pour mesurer le champ magnétique du noyau en fer doux (2), par un circuit intégré relié à l'enroulement secondaire (5) et dont la sortie est reliée à un dispositif de mesure ou à un circuit de déclenchement d'un appareil de coupure et par un circuit de compensation relié à l'enroulement secondaire (5) par l'intermédiaire d'un commutateur inverseur ou à un enroulement de compensation distinct enroulé sur le noyau en fer doux (2) et composé d'une source de courant continu (6) réglable et d'un circuit d'exploitation (9, 10, 11) qui traite la valeur du courant de la source de courant continu (6) lorsque le champ magnétique est compensé pour ajuster le circuit intégré.

5. Transducteur de mesure pour courant continu selon la revendication 4, **caractérisé en ce que** le noyau en fer doux (2) a un entrefer (3) dans lequel ou à proximité duquel est placé le détecteur de champ magnétique (4).

6. Transducteur de mesure pour courant continu selon la revendication 4 ou 5, **caractérisé en ce que** le détecteur de champ magnétique (4) est une sonde de Hall.

7. Transducteur de mesure pour courant continu selon la revendication 4 ou 5, **caractérisé en ce que** le détecteur de champ magnétique (4) est un capteur à magnétorésistance.

8. Transducteur de mesure pour courant continu selon la revendication 4 ou 5, **caractérisé en ce que** le détecteur de champ magnétique (4) est un enroulement indicateur (7) auquel on peut fournir un courant alternatif symétrique et dont la symétrie de tension peut être évaluée dans le circuit d'exploitation (9, 10, 11) pour mesurer le champ magnétique dans le noyau en fer doux (2).
